(19) **Europäisches Patentamt / European Patent Office / Office européen des brevets**

(11) **EP 1 555 756 B1**

(12) **EUROPEAN PATENT SPECIFICATION**

(45) Date of publication and mention
of the grant of the patent:
**25.07.2007 Bulletin 2007/30**

(51) Int Cl.:
***H03L 7/107*** *(2006.01)*

(21) Application number: **04000544.9**

(22) Date of filing: **13.01.2004**

(54) **Radio receiver having adaptive frequency regulator**

Funkempfänger mit adaptivem Frequenzregulator

Récepteur radio à régulateur de fréquence adaptif

(84) Designated Contracting States:
**AT BE BG CH CY CZ DE DK EE ES FI FR GB GR HU IE IT LI LU MC NL PT RO SE SI SK TR**

(43) Date of publication of application:
**20.07.2005 Bulletin 2005/29**

(73) Proprietor: **Harman/Becker Automotive Systems GmbH**
**76307 Karlsbad (DE)**

(72) Inventors:
• **Stefan Gierl**
**76133 Karlsruhe (DE)**

• **Andreas Koerner**
**76337 Waldbronn (DE)**
• **Christoph Benz**
**77797 Ohlsbach (DE)**

(74) Representative: **Bertsch, Florian Oliver et al**
**Kraus & Weisert**
**Patent- und Rechtsanwälte**
**Thomas-Wimmer-Ring 15**
**80539 München (DE)**

(56) References cited:
**EP-A- 0 503 416**     **EP-A- 0 954 103**
**EP-A- 1 115 205**     **US-A- 3 909 735**
**US-A- 5 121 085**     **US-A- 6 122 328**

Description

**BACKGROUND OF THE INVENTION**

**1. Field of the Invention.**
The invention relates to a radio receiver and in particular, to a radio having an adaptive frequency regulator.
**2. Related Art.**
Radio receivers are devices that enable the reception of information and music. Traditionally, a person would tune a radio receiver by turning a dial and selecting a desired frequency. More recently, electronic tuners in radio receivers have enabled persons to select a desired frequency by pressing a single button.
As electronic tuners have become more advanced, a distinction has been made between a listening receiver and a search receiver within a single radio receiver. A listening receiver is a receiver that is tuned to the frequency transmitted by a transmitter and outputs a radio signal or program derived from the information signal received from a transmitter. A search receiver identifies alternative frequencies that the same program may be received. If another frequency is found that allows better reception than the current frequency, then the listening receiver switches to the new frequency with better reception to ensure continuous reception of the program. Some approaches have been implemented with multiple receivers where the operation of the listening and search receivers occurs simultaneously. Such approaches enable the search receiver to find a frequency without interrupting the transmission of the information signal by the listening receiver.
In another approach, a single radio receiver alternates between the functions of the listening receiver and the search receiver. This is possible when the time intervals in which the receiver is used as a search receiver are so short that the resulting interruption in transmission of the information signal is not perceived by a listener, or the interruption in the program or information signal may be bridged by methods such as interpolation switching.
A known limitation with the single receiver approach is that the amount of time required retuning the receiver from a listening receiver at a current frequency to another set frequency that is being searched and back again to the original frequency. In order to keep an oscillator of the receiver on a set frequency, it is customary to use a regulator. The regulator determines the difference between the set frequency and the actual frequency of the oscillator and provides a regulator signal to the oscillator in an attempt to minimize the difference between the frequencies.
The response time with which this regulator signal follows the difference has to meet contradictory requirements. On the one hand, it must be short enough to lock in the desired search frequency during the time interval in which the radio receiver is used as the search receiver. On the other hand, it should not be so short that during operation as a listening receiver small reception disturbance in which the regulator erroneously picks up a difference from the set frequency results in a loss of tuning of the oscillator. The more sluggish the regulator and the more stable the setting to the listening frequency. The longer the time required to regulate a search frequency and the more difficult it is to cancel the dropout of the information signal in a phase of operation as a search receiver. Further, the regulator should be nimble enough that the interruption in the information signal during operation as a search receiver is not perceptible by a listener. Thus, there is a need in the art for a radio receiver that overcomes the disadvantages of the prior art radio receivers.
EP 1 115 205 discloses a PLL circuit and radio communication terminal using PLL, the design being simplified, the number of low-pass filters being reduced to only one so that the PLL circuit can reduce a mounting area and the number of pins.
US 5 121 085 discloses a dual charge pump bandwidth switched phase-locked loop wherein two charge pumps are used, one of which has a greater effect on the proportional component of a control signal and the other of which has a greater effect on the integral component.
EP 0 503 416 discloses a radio receiver according to the preamble of claim 1.

SUMMARY

This invention provides a radio receiver comprising an oscillator tunable to a frequency set by a frequency control mechanism and a regulator for minimizing the difference between the set frequency and the actual frequency of the oscillator according to claim 1. The regulator adjusts the regulator signal in response to a change in the difference with a set response time. A mechanism is capable of adjusting the frequency of the oscillator in response to the regulator signal to minimize the difference.
Other systems, methods, features and advantages of the invention will be or will become apparent to one with skill in the art upon examination of the following figures and detailed description.

**BRIEF DESCRIPTION OF THE FIGURES**

The components in the figures are not necessarily to scale, emphasis instead being placed upon illustrating the principles of the invention. In the figures, like reference numerals designate corresponding parts throughout the different views.

FIG. 1 is a block diagram of a radio receiver.

FIG. 2 is a block diagram of the RDS demodulator of FIG. 1.

FIG. 3 is a time diagram that shows a control signal delivered by the frequency control mechanism to the regulator as well as weighting coefficients used by the regulator in the course of several operating cycles of the regulator in the radio receiver of FIG. 2.

FIG. 4 is a time diagram showing the control signal and weighting coefficients in the course of one operating cycle of the regulator according to another embodiment.

FIG. 5 is a flow chart of the procedure steps of switching a radio receiver between a set frequency and a current frequency.

DETAILED DESCRIPTION

This invention provides a radio receiver that includes an oscillator. The oscillator may be tuned to a frequency of a transmitter. A frequency control mechanism for setting the frequency of the oscillator and a regulator detecting a difference between the set frequency and the actual frequency of the oscillator and delivering a regulator signal to the oscillator is also provided. The frequency of the oscillator is tuned in response to the regulator signal in order to minimize this difference. The frequency control mechanism may be set so that it tunes the oscillator to a first frequency in a first phase also called first operating mode of operation (listening phase) and to a second frequency in a second, shorter phase also called second operating mode (search phase). The second frequency may be an alternative frequency for reception of the same radio program transmitted on the first frequency.

In the second phase, the regulator signal may react, on average faster to a change in the difference between the set frequency and the actual frequency of the oscillator, than in the first phase. This means that the average response time with which the regulator signal follows a difference in frequency is longer in the first phase corresponding to listening operation than in the second phase corresponding to search operation. For both phases, the reaction rate of the regulator can be made independent and established appropriately according to the purpose of this phase.

**The regulator may be designed as a PI regulator. In a regulator of this type, whose** regulator signal comprises a "P" component proportional to the difference and an "I" component proportional to the integral of the difference over time, the relative proportion of the components of the regulator signal can be made variable. The PI regulator has the desirable property that systems with open loop transfer functions of type 1, or above, have a zero steady state error with respect to a step input.

In a first embodiment of the invention, variability in the response time of the regulator in the two phases may be achieved by the proportions of the two components of the regulator signal in the first phase being different from the proportions in the second phase. As an example, these values may be set to be invariable with one phase. To set the proportions in the regulator correctly, the frequency control mechanism may provide a control signal to the regulator that shows the phase of the frequency control mechanism the point in time in question.

The proportions of the components in the regulator signal may be defined in each phase as functions of the time elapsed since the beginning of the phase. For example, with increasing time, the proportion of the "I" component may be set to increase and that of the P component may be set to decrease. Therefore, at the beginning of each phase, the regulator signal therefore quickly follows a difference between the set frequency and the actual frequency of the oscillator. As the phase length increases, this following behavior slows down. Thus, resulting in the particular advantage that even at the beginning of a listening phase, when the oscillator has to be returned from the search frequency to the listening frequency, this can occur in a shorten time period.

The functions that describe the portions of the components of the regulator signal as a function of time can be the same for the first and second phases, so that the regulator does not need a control signal that shows the phase. Instead of this it is advantageous for the frequency control mechanism to deliver a control signal to the regulator that represents the time elapsed since the last transition of the frequency control mechanism between two phases.

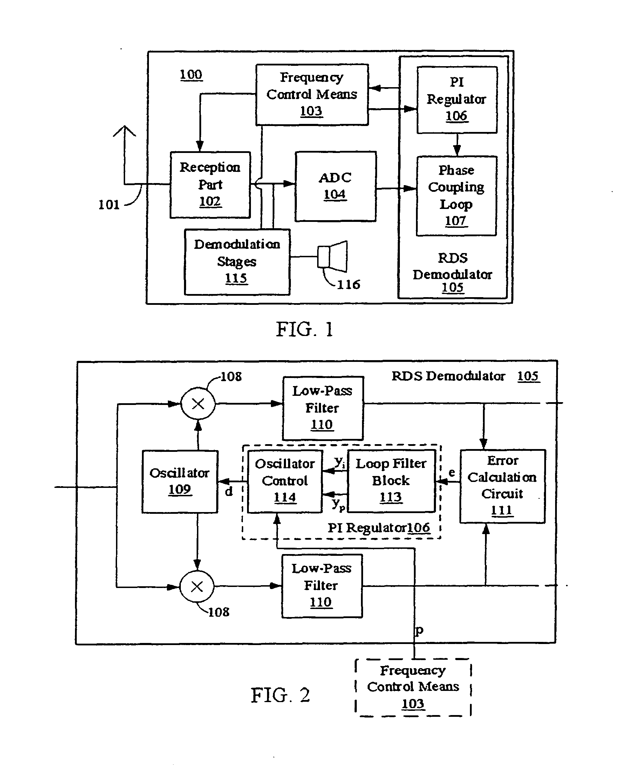

In FIG. 1, a block diagram illustrates a radio receiver 100. The radio receiver 100 receives, via antenna 101, signals from various transmitters, that may be obtained by modulating a multiplex signal. An example of a multiplex signal is a high-frequency signal created in a manner known as (L+R) audio signal in the 0-15 kHz frequency band, a stereo pilot tone at 19 kHz, a 23-53 kHz frequency band in which an (L-R) audio signal modulated to an auxiliary carrier at 38 kHz is transmitted, and a second auxiliary carrier at 57 kHz, that are modulated to the radio data system (RDS) signal. RDS data is used by receiver 100 to recognize the identity of the transmitter that transmits the signal that is received at a given frequency, and possibly to determine that different signals received at different frequencies are the same signal.

The reception frequency that the receiver's reception part 102 is tuned may be specified by a frequency control mechanism 103. The frequency control mechanism 103 may have two alternating operating phases: a listening operating phase and a search-operating phase. The reception frequencies specified for the reception part 102 are different in the two phases.

In the listening phases, which account for some of the operating time of the frequency control mechanism 103, the frequency control mechanism specifies the frequency of a transmitter selected by a user, and the multiplex signal transmitted by the reception part 102 is converted by a number of demodulation stages 115 as known by one of ordinary skill in the art and therefore not shown in further detail. The multiplex signal may be converted by the demodulation stages 115 into the L channel and R channel of a stereo audio signal, amplified in an amplification stage, and transmitted to the speaker 116. The loudspeaker 116 is shown as a single loudspeaker, but may be represented by multiple loudspeakers.

In the search phases that may be considerably shorter than the listening phases, the frequency control mechanism 103 may specify a frequency that differs from the listening frequency in order to check with what quality and from which transmitter a multiplex signal can be received at this frequency. In the search phases, the frequency control mechanism 103 may block the transmission of the multiplex signal to the loudspeaker 116.

The frequency control mechanism 103, may be, for example, a controller such as a microprocessor, digital signal processor, application specific integrated circuit (ASIC), discrete digital circuits functioning as a state machine, analog circuits functioning as a state machine, or any combination of the previous types of controllers or their derivatives.

The multiplex signal may also be fed via an analog-digital converter (ADC) 104 to an RDS demodulator 105. The purpose of the RDS demodulator 105 is to extract the RDS information from the multiplex signal and forward it to the frequency control mechanism 103. The structure of the RDS demodulator 105 with phase coupling loop 107 and PI regulator 106 is shown in detail in figure 2.

In FIG. 2, a block diagram of the RDS demodulator 105 of FIG. 1 is shown. The demodulator 105 has two processing lines for an in-phase and quadrature component of the digitized multiplex signal. In each of these lines, a multiplier 108 is located that receives the digitized signal at one input. A second input of the multiplier 108 is associated with an oscillator 109 that is tunable around a carrier frequency of the 57 kHz RDS signal. In other embodiments, the oscillator 109 may be tunable around a different carrier frequency than 57 KHz.

The digital oscillator 109 has a table of lengths N and a counter by which an entry in this table can be addressed. If LUT(n) designates the value in the table where address counter "n" is located, the table can be built according to the following formula:

$$LUT(n) = NINT(2^{(nbit-1)} \times \sin(2\pi n/N)) \qquad (n = 0, ... , N\text{-}1)$$

The table entries in this case are to be integrated as integers with a word length of n-bits.

The NINT (nearest integer) operation involves rounding to the nearest integer.

To generate a sine signal with a frequency $f_0$ (e.g., 57 kHz) at a scanning frequency $f_A$ (e.g., 176.4 kHz) using oscillator 109, in a simple embodiment it is sufficient, between two reading steps, to increment the address in the table by a fixed step width $\Delta n$. This step width can be calculated by the following equation:

$$\Delta n \quad = \quad NINT(N \times f_0/f_A).$$

For example, if N = 256, a counter increment of $\Delta n = 83$ results.

Rounding errors are undesirable. In order to avoid the rounding errors inevitable in the address calculation with this simple embodiment, it maybe desirable when calculating the addresses to use addresses with a length of mbit > nbit, where the additional bits represent certain fractions of an address step and do not become noticeable in the actual addressing of the LUT table until they have cumulated at least one complete address step.

The status of address counter "n" at a given reading point at time "k" is:

$$n(k) = (n(k-1) + \Delta n + n_0(k)) \qquad \text{modulo N}$$

Here, no(k) is a time-variable counter offset that produces a zero phase angle giving the sine oscillation stored in the table. This counter offset is proportional to a frequency correction signal "d", generation of which will be explained later.

The multipliers 108 deliver the sum and difference frequencies of their two input signals, i.e. the demodulated RDS signal and a component at 114 kHz, when oscillator 109 is precisely tuned. The latter component is suppressed by low-pass filter 110 that are each connected after a respective multiplier 108. The output signals of low-pass filters 110 are applied to an error signal calculation circuit 111. The error signal calculation circuit 111 determines the amount of a difference between the frequency of oscillator 109 and an actual RDS carrier frequency of the multiplex signal. The error calculation circuit 111 and delivers an error signal "e" to the PI regulator 106. The PI regulator 106 may have a loop filter block 113 that receives the error signal "e" and derives two intermediate regulator signals "$y_p$", "$y_i$". The regulator signal "$y_p$" is directly proportional to the error e, and the regulator signal "$y_i$" is proportional to a time integral of error "e". The two regulator signals "$y_p$", "$y_i$" are applied to the inputs of an oscillator control block 114 which, under the influence of frequency control mechanism 103, links the signals "$y_i$" and "$y_p$" to a frequency correction signal "d" for oscillator 109. This linkage takes place by weighted addition of the signals "$y_p$" and "$y_i$" with weighting coefficients "$c_i$" and "$c_p$" according to the formula:

$$d = c_i \times y_i + c_p \times y_p.$$

The oscillator 109 obtains from the above the counter offset $n_0(k)=NINT(Nd/2\pi)$.
The coefficients "$c_i$" and "$c_p$" are time-variable depending on a control signal "p" delivered by frequency control mechanism 103 to the oscillator control block 114.

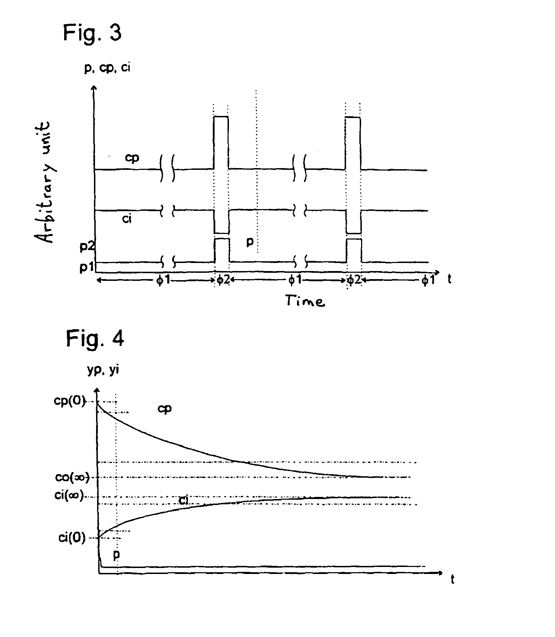

A first embodiment of control signal "p" and the time variability of the coefficients "$c_p$", "$c_i$" is shown in FIG 3. With this embodiment, in the course of time "t," the control signal "p" may assume two different levels, namely, in the course of a first operating phase φ1 of frequency control mechanism 103, level $p_1$ and during a second, shorter, operating phase φ2, level $p_2$. Corresponding to the level of control signal "p," applied to the input of oscillator control block 114, this signal selects the coefficients "$c_p$", "$c_i$" as shown in FIG. 3. During the relatively long, first phases φ1, the value of "$c_p$" is smaller than in the second phases φ2, and the value of "$c_i$" is high in the first phases and low in the second phases. In this way, a regulating rate of the oscillator 109 may be achieved that is different from phase to phase, with which this reacts to differences between its set frequency and its actual frequency. In the phases φ1, that may correspond to the listening operation of a radio, when the contribution of the integral term of correction signal "d" is high, the regulation is sluggish, preventing synchronization from being lost in the event of a brief disturbance in reception, while in the second phases φ2 corresponding to the search phases of the radio, the proportional contribution to correction signal "d" is predominant, so that the oscillator 109 can quickly lock into the RDS sub-carrier of the multiplex signal and the RDS signal can be decoded.

A second embodiment of the control signal "p," and the time-variability of the coefficients "ci" and "cp" is shown in FIG 4. Here, the control signal "p" is in the form of pulses sent on each occasion by the frequency control mechanism 103 when there is a transition from one of the two phases φ1, φ2 to the other. The oscillator control block 114 reacts to reception of such a pulse, in which it sets the coefficients "$c_p$" and "$c_i$" to an initial value $c_p(0)$ or $c_i(0)$. From this initial value, the coefficient "$c_p$" decreases over time while coefficient "$c_i$" increases. The two coefficients converge over time to a boundary value $c_p(\infty)$ or $c_i(\infty)$. In the first phases φ1, this boundary value is reached as well. The second phases φ2 are so short, however, that a new pulse of control signal "p" arrives long before the boundary value is reached. Thus, averaged over the duration of a phase the contribution of the proportional terms ($c_p \times y_p$) to the correction signal "d" in the first phases φ1 is small and in the second phases φ2 is large, while the ratio for the integral term ($c_i \times y_i$) is exactly the reverse. In this way, swift regulation of the oscillator 109 is achieved with a frequency difference in the second phases φ2 and sluggish regulation in the first phases φ1. A particular advantage of this embodiment is that the rate of regulation is high at the beginning of each first phase φ1. This means that, not only is a fast lock-in of the oscillator 109 possible at the beginning of a search phase, but also at the beginning of a listening phase. Only in the course of the listening phase, when the oscillator 109 is locked in, does the regulation increase in sluggishness and hence in stability.

A structure analogous to that of FIG. 2 may also be used in reception part 102 in order to enable rapid tuning to radio frequencies that alternate between the listening and search phases. The structure of the regulating circuit can be the same in this case as that shown in FIG 2 with the only significant difference since the signal to be processed is a radio frequency signal and not the multiplex signal displaced into the base band.

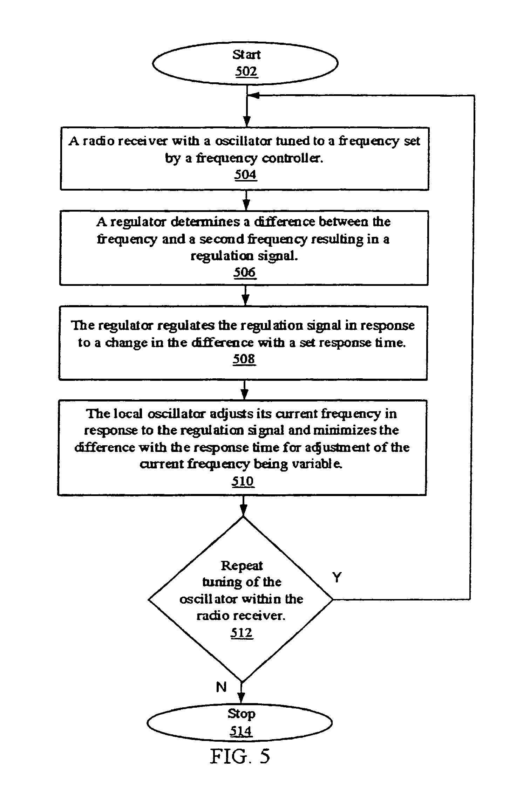

In FIG. 5, a flow chart of the procedure steps of switching a radio receiver between a set frequency and a current frequency. The procedure starts 502 with the radio receiver 100 having an oscillator 109 tuned to a frequency 504 set by the frequency control mechanism 103. A PI regulator 106 determines a difference between the current frequency and a second frequency and results in a regulator signal 506.

The PI regulator 106 regulates the regulator signal in response to a change in the difference with a set response time 508. The frequency of the oscillator (109) is tuned in response to reception of the regulator signal and minimizes the difference with the response time for adjustment of the current frequency being variable 510.

The tuning of oscillator 109 within the radio receiver 100 is repeated while the radio is operation 504 until an event occurs. An example of such an event is the radio being turned off, resulting in the procedure stopping 514. In alternate embodiment, the tuning of oscillator 109 may occur at predetermined intervals, upon detection of an event, or even upon enable in response to a user interface.

It is appreciated by those skilled in the art that the process shown in FIG. 5 may selectively be implemented with analog and digital hardware that includes software controlling programmable devices. An embodiment of the process steps employs at least one machine-readable signal-bearing medium. Examples of machine-readable signal bearing mediums include computer-readable mediums such as a magnetic storage medium (i.e. floppy disks, or optical storage such as compact disk (CD) or digital video disk (DVD)), a biological storage medium, or an atomic storage medium, a discrete logic circuit(s) having logic gates for implementing logic functions upon data signals, an application specific integrated circuit having appropriate logic gates, a programmable gate array(s) (PGA), a field programmable gate array (FPGA), a random access memory device (RAM), read only memory device (ROM), electronic programmable random access memory (EPROM), or equivalent. Note that the computer-readable medium could even be paper or another suitable medium, upon which the computer instruction is printed, as the program can be electronically captured, via for instance optical scanning of the paper or other medium, then compiled, interpreted or otherwise processed in a suitable manner if necessary, and then stored in a computer memory.

Additionally, machine-readable signal bearing medium includes computer-readable signal bearing mediums. Computer-readable signal bearing mediums have a modulated carrier signal transmitted over one or more wire based, wireless or fiber optic networks or within a system. For example, one or more wire based, wireless or fiber optic network, such as the telephone network, a local area network, the Internet, or a wireless network having a component of a computer-readable signal residing or passing through the network. The computer readable signal is a representation of one or more machine instructions written in or implemented with any number of programming languages.

Furthermore, the multiple process steps implemented with a programming language, which comprises an ordered listing of executable instructions for implementing logical functions, can be embodied in any machine-readable signal bearing medium for use by or in connection with an instruction execution system, apparatus, or device, such as a computer-based system, controller-containing system having a processor, microprocessor, digital signal processor, discrete logic circuit functioning as a controller, or other system that can fetch the instructions from the instruction execution system, apparatus, or device and execute the instructions.

**Claims**

**1.** Radio receiver (100), comprising:

- an oscillator (109) for outputting a signal at a tunable frequency;
- a regulator (106)

- for receiving a signal (e) representative of a difference between a set frequency and the actual frequency of the output signal of the oscillator (109),
- for delivering with a response time a tuning signal (d) to the oscillator (109) in response to a change in said signal (e) representative of a difference in frequency so as to minimize the difference between the set frequency and the actual frequency of the output signal of the oscillator (109),
- comprising two operating modes:

- a first operating mode with a first response time,
- a second operating mode with a second response time being shorter on average than the first response time,
- whereby the response time varies over time;

- a frequency control mechanism (103) for selectively enabling the first operating mode and the second operating mode;

**characterized in that**

- within both the first operating mode and the second operating mode the response time decreases over time and is longer in the first operating mode than in the second operating mode.

**2.** Radio receiver according to claim 1, **characterized in that** a time dependence of the response time for the first operating mode and the second operating mode are similar.

3. Radio receiver according to any of the preceding claims, **characterized in that** the set frequency in the first operating mode and the second operating mode are the same.

4. Radio receiver according to claim 3, **characterized in that** the set frequency is a RDS sub-carrier frequency within a multiplex signal.

5. Radio receiver according to one of claims 1,2,4 **characterized in that** the oscillator (109) is tuned to a first frequency in the first operating mode in response to the frequency controller (103) and tuned to a second frequency in the second operating mode.

6. Radio receiver according to claim 5, **characterized in that** the first frequency and the second frequency are radio signal frequencies.

7. Radio receiver according to any of the preceding claims, **characterized in that** the regulator (106) is a PI regulator.

8. Radio receiver according to any of the preceding claims, **characterized in that** the regulator signal further comprises a P component proportional to the difference and an I component proportional to the integral of the difference with a relative weight $c_i$ and a relative weight $c_p$ of the components in the regulator signal being variable.

9. Radio receiver according to claim 8, **characterized in that** the relative weights $c_i$ and $c_p$ of the P component and the I component in the first operating mode are different from the relative weights in the second operating mode.

10. Radio receiver according to claim 8 or 9, **characterized in that** the weights $c_i$ and $c_p$ of the components of the regulator signal in the first operating mode and the second operating mode individually vary as a function of time elapsed since beginning of the first operating mode and the second operating mode, with said response time being increased since beginning of the first operating mode and the second operating mode, the relative weight $c_i$ of the I component being increased and the relative weight $c_p$ of the P component being decreased.

11. Method of radio reception comprising the following steps:

   - generating a signal at a tunable frequency with an oscillator (109);
   - receiving a signal representative of a difference between a set frequency and the actual frequency of the output signal of the oscillator (109) with a regulator (106);
   - delivering with a response time a tuning signal to the oscillator (109) in response to a change in said signal representative of a difference in frequency so as to minimize the difference between the set frequency and the actual frequency of the output signal of the oscillator (109), the response time varying over time;
   wherein the step of generating a signal at a tunable frequency further comprises two operating modes:

      - a first operating mode with a first response time,
      - a second operating mode with a second response time being shorter on average than the first response time,

   - selectively enabling the first operating mode and the second operating mode;
   **characterized in that**

   within both the first operating mode and the second operating mode the response time decreases over time and is longer in the first operating mode than in the second operating mode.

12. Method according to claim 11, **characterized in that** a time dependence of the response time for the first operating mode and the second operating mode are similar.

13. Method according to any of claims 11 or 12, **characterized in that** the set frequency in the first operating mode and the second operating mode are the same.

14. Method according to claim 13, **characterized in that** the step of setting further comprises setting the oscillator (109) to a set frequency that is a RDS sub-carrier frequency within a multiplex signal.

**15.** Method according to any of claims 11-14, **characterized by** further comprising tuning of the oscillator (109) from a first frequency in the first operating mode to a second frequency in the second operating mode in response to the frequency controller (114).

**16.** Method according to any of claims 11-15, **characterized in that** the first frequency and the second frequency are radio signal frequencies.

**17.** Method according to any of claims 11-16, **characterized in that** the step of delivering further comprises generating the regulator signal with a PI regulator (106).

**18.** Method according to claim 17, further comprising determining a P component proportional to the difference and an I component proportional to the integral of the difference, with a relative weight $c_i$ and a relative weight $c_p$ of the components in the I regulator signal being variable.

**19.** Method according to claim 18, **characterized in that** the relative weights $c_i$ and $c_p$ of the P component and the I component in the first operating mode are different from the relative weights in the second operating mode.

**20.** Method according to claim 18, **characterized by** further comprising increasing said response time since beginning of the first operating mode and the second operating mode, the relative weight $c_i$ of the I component being increased and the relative weight $c_p$ of the P component being decreased where the weights $c_i$ and $c_p$ of the components of the regulator signal in the first operating mode and the second operating mode individually vary as a function of time elapsed since the beginning of the first operating mode and the second operating mode.

**Patentansprüche**

**1.** Funkempfänger (100) umfassend:

- einen Oszillator (109) zum Ausgeben eines Signals bei einer einstellbaren Frequenz;
- einen Regler (106)

- zum Empfangen eines Signals (e), welches eine Differenz zwischen einer vorgegebenen Frequenz und einer tatsächlichen Frequenz des Ausgabesignals des Oszillators (109) darstellt,
- zum Abgeben eines Einstellsignals (d) mit einer Antwortzeit zu dem Oszillator (109) in Abhängigkeit von einer Änderung des Signals (e), welches eine Frequenzdifferenz darstellt, um die Differenz zwischen der vorgegebenen Frequenz und der tatsächlichen Frequenz des Ausgabesignals des Oszillators (109) zu minimieren,
- umfassend zwei Betriebsarten:

- eine erste Betriebsart mit einer ersten Antwortzeit,
- eine zweite Betriebsart mit einer zweiten Antwortzeit, welche im Durchschnitt kürzer als die erste Antwortzeit ist,
- wobei sich die Antwortzeit über der Zeit ändert;

- ein Frequenzsteuermechanismus (103) zum wahlweisen Freigeben der ersten Betriebsart und der zweiten Betriebsart;
**dadurch gekennzeichnet, dass**
- sich innerhalb sowohl der ersten Betriebsart als auch der zweiten Betriebsart die Antwortzeit über der Zeit verringert und in der ersten Betriebsart länger als in der zweiten Betriebsart ist.

**2.** Funkempfänger nach Anspruch 1, **dadurch gekennzeichnet, dass** eine Zeitabhängigkeit der Antwortzeit für die erste Betriebsart und die zweite Betriebsart ähnlich ist.

**3.** Funkempfänger nach einem der vorhergehenden Ansprüche, **dadurch gekennzeichnet, dass** die vorgegebene Frequenz in der ersten Betriebsart und in der zweiten Betriebsart die gleiche ist.

**4.** Funkempfänger nach Anspruch 3, **dadurch gekennzeichnet, dass** die vorgegebene Frequenz eine RDS-Unterträgerfrequenz innerhalb eines Multiplexsignals ist.

5. Funkempfänger nach einem der Ansprüche 1, 2, 4, **dadurch gekennzeichnet, dass** der Oszillator (109) in Abhängigkeit von der Frequenzsteuerung (103) in der ersten Betriebsart auf eine erste Frequenz eingestellt ist und in der zweiten Betriebsart auf eine zweite Frequenz eingestellt ist.

6. Funkempfänger nach Anspruch 5, **dadurch gekennzeichnet, dass** die erste Frequenz und die zweite Frequenz Funksignalfrequenzen sind.

7. Funkempfänger nach einem der vorhergehenden Ansprüche, **dadurch gekennzeichnet, dass** der Regler (106) ein PI-Regler ist.

8. Funkempfänger nach einem der vorhergehenden Ansprüche, **dadurch gekennzeichnet, dass** das Regelsignal ferner eine P-Komponenten proportional zu der Differenz und eine I-Komponente proportional zu dem Integral der Differenz umfasst, wobei ein relatives Gewicht ci und ein relatives Gewicht cp der Komponenten in dem Regelsignal variabel sind.

9. Funkempfänger nach Anspruch 8, **dadurch gekennzeichnet, dass** die relativen Gewichte ci und cp der P-Komponente und I-Komponente in der ersten Betriebsart unterschiedlich zu den relativen Gewichten in der zweiten Betriebsart sind.

10. Funkempfänger nach Anspruch 8 oder 9, **dadurch gekennzeichnet, dass** sich die Gewichte ci und cp der Komponenten des Regelsignals in der ersten Betriebsart und der zweiten Betriebsart individuell als eine Funktion der abgelaufenen Zeit seit einem Anfang der ersten Betriebsart und der zweiten Betriebsart verändern, wobei die Antwortzeit ab dem Anfang der ersten Betriebsart und der zweiten Betriebsart erhöht wird, wobei das relative Gewicht ci der I-Komponente erhöht wird und das relative Gewicht cp der P-Komponente verringert wird.

11. Verfahren eines Funkempfangs, umfassend die folgenden Schritte:

- Erzeugen eines Signals bei einer einstellbaren Frequenz mit einem Oszillator (109);
- Empfangen eines Signals, welches eine Differenz zwischen einer vorgegebenen Frequenz und der tatsächlichen Frequenz des Ausgabesignals des Oszillators (109) darstellt, mit einem Regler (106);
- nach einer Antwortzeit Abgeben eines Einstellsignals zu dem Oszillator (109) in Abhängigkeit von einer Änderung des Signals, welches eine Frequenzdifferenz darstellt, um die Differenz zwischen der vorgegebenen Frequenz und der tatsächlichen Frequenz des Ausgabesignals des Oszillators (109) zu minimieren, wobei sich die Antwortzeit über der Zeit verändert;

wobei der Schritt eines Erzeugens eines Signals bei einer einstellbaren Frequenz ferner zwei Betriebsarten umfasst:

- eine erste Betriebsart mit einer ersten Antwortzeit,
- eine zweite Betriebsart mit einer zweiten Antwortzeit, welche im Durchschnitt kürzer als die erste Antwortzeit ist,

- wahlweises Freigeben der ersten Betriebsart und der zweiten Betriebsart;
**dadurch gekennzeichnet, dass**

sich innerhalb sowohl der ersten Betriebsart als auch der zweiten Betriebsart die Antwortzeit über der Zeit verringert und in der ersten Betriebsart länger als in der zweiten Betriebsart ist.

12. Verfahren nach Anspruch 11, **dadurch gekennzeichnet, dass** eine Zeitabhängigkeit der Antwortzeit für die erste Betriebsart und die zweite Betriebsart ähnlich ist.

13. Verfahren nach einem der Ansprüche 11 oder 12, **dadurch gekennzeichnet, dass** die vorgegebene Frequenz in der ersten Betriebsart und in der zweiten Betriebsart die gleiche ist.

14. Verfahren nach Anspruch 13, **dadurch gekennzeichnet, dass** der Schritt des Einstellens ferner ein Einstellen des Oszillators (109) auf eine vorgegebene Frequenz umfasst, welche eine RDS-Unterträgerfrequenz innerhalb eines Multiplexsignals ist.

15. Verfahren nach einem der Ansprüche 11-14, **dadurch gekennzeichnet, dass** das Verfahren ferner ein Einstellen des Oszillators (109) von einer ersten Frequenz in der ersten Betriebsart auf eine zweite Frequenz in der zweiten Betriebsart in Abhängigkeit von der Frequenzsteuerung (114) umfasst.

**16.** Verfahren nach einem der Ansprüche 11-15, **dadurch gekennzeichnet, dass** die erste Frequenz und die zweite Frequenz Funksignalfrequenzen sind.

**17.** Verfahren nach einem der Ansprüche 11-16, **dadurch gekennzeichnet, dass** der Schritt des Abgebens ferner ein Erzeugen des Regelsignals mit einem PI-Regler (106) umfasst.

**18.** Verfahren nach Anspruch 17, ferner umfassend ein Bestimmen einer P-Komponente proportional zu der Differenz und einer I-Komponenten proportional zu dem Integral der Differenz, wobei ein relatives Gewicht ci und ein relatives Gewicht cp der Komponenten in dem Regelsignal variable sind.

**19.** Verfahren nach Anspruch 18, **dadurch gekennzeichnet, dass** die relativen Gewichte ci und cp der P-Komponente und der I-Komponente in der ersten Betriebsart unterschiedlich zu den relativen Gewichten in der zweiten Betriebsart sind.

**20.** Verfahren nach Anspruch 18, **dadurch gekennzeichnet, dass** das Verfahren ferner umfasst: ein Erhöhen der Antwortzeit seit einem Anfang der ersten Betriebsart und der zweiten Betriebsart, wobei das relative Gewicht ci der I-Komponente erhöht wird und das relative Gewicht cp der P-Komponente verringert wird, wobei sich die Gewichte ci und cp der Komponenten des Regelsignals in der ersten Betriebsart und der zweiten Betriebsart individuell als eine Funktion der Zeit, welche seit dem Anfang der ersten Betriebsart und der zweiten Betriebsart abgelaufen ist, verändern.

**Revendications**

**1.** Récepteur radio (100), comprenant :

- un oscillateur (109) pour restituer un signal à une fréquence réglable ;
- un régulateur (106)

- pour recevoir un signal (e) représentatif d'une différence entre une fréquence fixée et la fréquence réelle du signal de sortie de l'oscillateur (109),
- pour délivrer avec un temps de réponse d'un signal de réglage (d) à l'oscillateur (109) en réponse à un changement dans ledit signal (e) représentatif d'une différence en fréquence de façon à minimiser la différence entre la fréquence fixée et la fréquence réelle du signal de sortie de l'oscillateur (109),
- comprenant deux modes de fonctionnement :

- un premier mode de fonctionnement avec un premier temps de réponse,
- un second mode de fonctionnement avec un second temps de réponse plus court en moyenne que le premier temps de réponse,
- où le temps de réponse varie au cours du temps ;

- un mécanisme de commande de fréquence (103) pour sélectivement permettre le premier mode de fonctionnement et le second mode de fonctionnement ;
**caractérisé en ce que**
- dans à la fois le premier mode de fonctionnement et le second mode de fonctionnement le temps de réponse diminue au cours du temps et est plus long dans le premier mode de fonctionnement que dans le second mode de fonctionnement.

**2.** Récepteur radio selon la revendication 1, **caractérisé en ce que** les dépendances de temps du temps de réponse pour le premier mode de fonctionnement et le second mode de fonctionnement sont similaires.

**3.** Récepteur radio selon l'une quelconque des revendications précédentes, **caractérisé en ce que** les fréquences fixées dans le premier mode de fonctionnement et le second mode de fonctionnement sont les mêmes.

**4.** Récepteur radio selon la revendication 3, **caractérisé en ce que** la fréquence fixée est une fréquence sous-porteuse RDS dans un signal multiplexe.

5. Récepteur radio selon l'une quelconque des revendications 1, 2, 4, **caractérisé en ce que** l'oscillateur (109) est réglé sur une première fréquence dans le premier mode de fonctionnement en réponse au contrôleur de fréquence (103) et réglé à une seconde fréquence dans le second mode de fonctionnement.

6. Récepteur radio selon la revendication 5, **caractérisé en ce que** la première fréquence et la seconde fréquence sont des fréquences de signal radio.

7. Récepteur radio selon l'une quelconque des revendications précédentes, **caractérisé en ce que** le régulateur (106) est un régulateur PI.

8. Récepteur radio selon l'une quelconque des revendications précédentes, **caractérisé en ce que** le signal de régulateur comprend en outre un composant P proportionnel à la différence et un composant 1 proportionnel à l'intégrale de la différence avec un poids relatif ci et un poids relatif cp des composants dans le signal de régulateur variable.

9. Récepteur radio selon la revendication 8, **caractérisé en ce que** les poids relatifs ci et cp du composant P et du composant I dans le premier mode de fonctionnement sont différents des poids relatifs dans le second mode de fonctionnement.

10. Récepteur radio selon la revendication 8 ou 9, **caractérisé en ce que** les poids ci et cp des composants du signal de régulateur dans le premier mode de fonctionnement et le second mode de fonctionnement varient individuellement en fonction du temps écoulé depuis le début du premier mode de fonctionnement et du second mode de fonctionnement, avec ledit temps de réponse augmentant depuis le début du premier mode de fonctionnement et du second mode de fonctionnement, le poids relatif ci du composant 1 étant augmenté et le poids relatif cp du composant P étant diminué.

11. Procédé de réception radio comprenant les étapes suivantes :

   - générer un signal à une fréquence réglable avec un oscillateur (109) ;
   - recevoir un signal représentatif d'une différence entre une fréquence fixée et la fréquence réelle du signal de sortie de l'oscillateur (109) avec un régulateur (106) ;
   - délivrer avec un temps de réponse un signal de réglage à l'oscillateur (109) en réponse à un changement dans ledit signal représentatif d'une différence en fréquence de façon à minimiser la différence entre la fréquence fixée et la fréquence réelle du signal de sortie de l'oscillateur (109), le temps de réponse variant au cours du temps ;
   dans lequel l'étape de générer un signal a une fréquence réglable comprend en outre deux modes de fonctionnement :

      - un premier mode de fonctionnement avec un premier temps de réponse,
      - un second mode de fonctionnement avec un second temps de réponse qui est plus court en moyenne que le premier temps de réponse,

      - sélectivement permettre le premier mode de fonctionnement et le second mode de fonctionnement ;
      **caractérisé en ce que**

   dans à la fois le premier mode de fonctionnement et le second mode de fonctionnement le temps de réponse décroît au cours du temps et est plus long dans le premier mode de fonctionnement que dans le second mode de fonctionnement.

12. Procédé selon la revendication 11, **caractérisé en ce que** les dépendances de temps du temps de réponse pour le premier mode de fonctionnement et le second mode de fonctionnement sont similaires.

13. Procédé selon l'une quelconque des revendications 11 ou 12, **caractérisé en ce que** les fréquences fixées dans le premier mode de fonctionnement et le second mode de fonctionnement sont les mêmes.

14. Procédé selon la revendication 13, **caractérisé en ce que** l'étape de fixer comprend en outre de fixer l'oscillateur (109) à une fréquence fixée qui est une fréquence sous-porteuse RDS dans un signal multiplexe.

**15.** Procédé selon l'une quelconque des revendications 11-14, **caractérisé en ce qu'**il comprend en outre de régler l'oscillateur (109) depuis une première fréquence dans le premier mode de fonctionnement vers une seconde fréquence dans le second mode de fonctionnement en réponse au contrôleur de fréquence (114).

**16.** Procédé selon l'une quelconque des revendications 11-15, **caractérisé en ce que** la première fréquence et la seconde fréquence sont des fréquences de signal radio.

**17.** Procédé selon l'une quelconque des revendications 11-16, **caractérisé en ce que** l'étape de délivrer comprend en outre de générer le signal régulateur avec un régulateur PI (106).

**18.** Procédé selon la revendication 17, comprenant en outre de déterminer un composant P proportionnel à la différence et un composant 1 proportionnel à l'intégrale de la différence, avec un poids relatif ci et un poids relatif cp des composants dans le signal régulateur variable.

**19.** Procédé selon la revendication 18, **caractérisé en ce que** les poids relatifs ci et cp du composant P et du composant 1 dans le premier mode de fonctionnement sont différents des poids relatifs dans le second mode de fonctionnement.

**20.** Procédé selon la revendication 18, **caractérisé en ce qu'**il comprend en outre d'augmenter ledit temps de réponse depuis le début du premier mode de fonctionnement et du second mode de fonctionnement, le poids relatif ci du composant 1 étant augmenté et le poids relatif cp du composant P étant diminué où les poids ci et cp des composants du signal de régulateur dans le premier mode de fonctionnement et le second mode de fonctionnement varient individuellement en fonction du temps écoulé depuis le début du premier mode de fonctionnement et du second mode de fonctionnement.

FIG. 1

FIG. 2

## Fig. 3

## Fig. 4

Start
502

A radio receiver with a oscillator tuned to a frequency set
by a frequency controller.
504

A regulator determines a difference between the
frequency and a second frequency resulting in a
regulation signal.
506

The regulator regulates the regulation signal in response
to a change in the difference with a set response time.
508

The local oscillator adjusts its current frequency in
response to the regulation signal and minimizes the
difference with the response time for adjustment of the
current frequency being variable.
510

Repeat
tuning of the
oscillator within the
radio receiver.
512

Y

N

Stop
514

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1115205 A
- US 5121085 A
- EP 0503416 A